# EUROPEAN PATENT APPLICATION

(11) **EP 4 140 788 A1**
(43) Date of publication of application: **01.03.2023**
(21) Application number: 21837956.8
(22) Date of filing: 08.07.2021
(51) Int. Cl.: B60K 1/00, B60K 11/04, H02K 9/00, H02K 9/19, H05K 7/20

(54) **POWERTRAIN COOLING SYSTEM AND METHOD, POWERTRAIN, AND ELECTRIC VEHICLE**

(30) Priority: 08.07.2020 CN 202010652837
(71) Applicant: Huawei Digital Power Technologies Co., Ltd., Shenzhen, Guangdong 518043 (CN)
(72) Inventor: WANG, Jiangang, Shenzhen, Guangdong 518129 (CN); LI, Quanming, Shenzhen, Guangdong 518129 (CN); CHEN, Jun, Shenzhen, Guangdong 518129 (CN)
(74) Representative: Pfenning, Meinig & Partner mbB
(86) International application number: PCT/CN2021/105186
(87) International publication number: WO 2022/007884

(57) **Abstract**

This application provides a powertrain cooling system and method, a powertrain, and an electric vehicle, and relates to the field of electric vehicle technologies. The cooling system includes a cooling circuit and a cooling working substance. The cooling circuit includes a first cooling channel and a second cooling channel that are connected. The first cooling channel is configured to dissipate heat of an inverter of the electric vehicle. The second cooling channel is configured to dissipate heat of a motor of the electric vehicle. The cooling working substance is an insulating working substance, and the cooling working substance flows from the first cooling channel into the second cooling channel. The cooling system can improve an effect of dissipating heat of the powertrain.

## Description

This application claims priority to Chinese Patent Application No. 202010652837.X, filed with China National Intellectual Property Administration on July 8, 2020, and entitled "POWERTRAIN COOLING SYSTEM AND METHOD, POWERTRAIN, AND ELECTRIC VEHICLE", the entire content of which is incorporated herein by reference.

### TECHNICAL FIELD

This application relates to the field of electric vehicle technologies, and in particular, to a powertrain cooling system and method, a powertrain, and an electric vehicle.

### BACKGROUND

A powertrain of an electric vehicle includes a motor (an engine), a direct current-alternating current (DC-AC) inverter (referred to as an inverter hereinafter), a motor control system, and a gearbox. A process in which a powertrain cooling system dissipates heat of the motor and the gearbox through an oil cooling circuit and dissipates heat of the inverter through a water cooling circuit implements primary heat dissipation, and a process in which the powertrain cooling system transfers heat of the oil cooling circuit to the water cooling circuit through an oil-water heat exchanger implements secondary heat dissipation.

Evolution of the powertrain towards miniaturization requires continuous improvement of a maximum rotational speed of the powertrain, so that a miniaturized powertrain can output a power the same as that of an existing powertrain. That the powertrain with a smaller volume outputs the power the same as that of the existing powertrain means an increase in a heat consumption density. Therefore, heat needs to be dissipated timely and efficiently.

However, the oil-water heat exchanger responsible for heat exchange between the oil cooling circuit and the water cooling circuit hits a bottleneck in efficiency of secondary heat exchange, and can implement the secondary heat exchange only when there is a temperature difference. Therefore, a temperature of an oil coolant is higher than that of a water coolant and a temperature of the motor increases correspondingly, resulting in a poor heat dissipation effect.

### SUMMARY

To resolve the foregoing technical problem in the conventional technology, this application provides a powertrain cooling system and method, a powertrain, and an electric vehicle, so that an effect of dissipating heat of the powertrain can be improved.

According to a first aspect, this embodiment of this application provides a powertrain cooling system. The cooling system is applied to an electric vehicle, and includes a cooling circuit and a cooling working substance. The cooling circuit includes a first cooling channel and a second cooling channel that are connected. The first cooling channel is configured to dissipate heat of an inverter of the electric vehicle, and the second cooling channel is configured to dissipate heat of a motor of the electric vehicle. A cooling working substance used in the cooling circuit is an insulating working substance. The cooling working substance flows from the first cooling channel into the second cooling channel.

The cooling working substance used in this application is an insulating working substance, and the insulating working substance is a non-aqueous working substance. In some embodiments, an insulating working substance with low viscous resistance is used, that is, the viscous resistance of the insulating working substance is lower than that of an oil coolant, so that contact spray cooling may be implemented on the inside of the motor and contact cooling may be implemented on a chip of the inverter. The cooling system can improve an effect of dissipating the heat of the motor without performing secondary heat exchange between a water cooling circuit and an oil cooling circuit through an oil-water heat exchanger.

With reference to the first aspect, in a first possible implementation, the cooling system further includes a bypass valve and a bypass cooling channel. The bypass valve is a controllable valve, and the first cooling channel is connected to the second cooling channel through the bypass valve. The bypass cooling channel and the second cooling channel are connected in parallel, and the bypass valve is configured to increase, in a process in which a thermal power of the inverter is increased, or when it is determined that a thermal power of the inverter is to be increased, a proportion of the cooling working substance that is in the first cooling channel and that flows into the bypass cooling channel.

In this implementation, the bypass valve is used to control and increase the proportion of the cooling working substance flowing into the bypass cooling channel, so that the cooling working substance flowing into the bypass cooling channel absorbs less heat, is cooled faster, and circulates to the first cooling channel faster, to dissipate the heat of the inverter again. Therefore, a flow rate of the cooling working substance in the first cooling channel is increased, to further improve a capability of dissipating the heat of the inverter 11.

With reference to the first aspect, in a second possible implementation, the bypass valve is a solenoid valve, and the cooling system further includes a temperature sensor and a motor controller. The temperature sensor is configured to obtain a temperature of the inverter and send the temperature to the motor controller. The motor controller is configured to control an operating state of the bypass valve when the temperature of the inverter is greater than a preset threshold, so that all the cooling working substance in the first cooling channel flows into the bypass cooling channel. Therefore, a capability of dissipating the heat of the inverter is improved to the greatest extent, to rapidly dissipate the heat of the inverter.

With reference to the first aspect, in a third possible implementation, the cooling system may also dissipate heat of a gearbox of the motor. In this case, the cooling system further includes an oil cooling circuit. The cooling circuit is isolated from the oil cooling circuit, and a cooling working substance in the oil cooling circuit is an oil coolant. When a gear of the gearbox rotates, the oil coolant can be agitated, to drive the oil cooling circuit. The oil cooling circuit of the cooling system dissipates heat of the gearbox of the electric vehicle.

With reference to the first aspect, in a fourth possible implementation, to isolate the cooling circuit from the oil cooling circuit, the cooling system further includes a bearing and a high-speed oil seal. The bearing and the high-speed oil seal are disposed at a connection end between a motor shaft of the motor and the gearbox.

With reference to the first aspect, in a fifth possible implementation, the powertrain cooling system and an integrated vehicle thermal management circuit are independent of each other, and the cooling system is not connected to the integrated vehicle thermal management circuit. In this case, the cooling system needs to exchange heat with the integrated vehicle thermal management circuit by using a heat exchanger. The heat exchanger includes a first heat exchange channel and a second heat exchange channel. An input end of the first heat exchange channel is connected to the second cooling channel, an output end of the first heat exchange channel is connected to the first cooling channel, and the second heat exchange channel is connected to the integrated vehicle thermal management circuit of the electric vehicle. After the cooling working substance in the second heat exchange channel absorbs heat of the cooling working substance in the first heat exchange channel, heat dissipation is performed through the integrated vehicle thermal management circuit.

The foregoing implementations are applicable to a scenario in which the powertrain cooling system and the integrated vehicle thermal management circuit need to be independently designed.

With reference to the first aspect, in a sixth possible implementation, the cooling working substance is used for performing contact spray cooling on the motor. To be specific, the cooling working substance may be in direct contact with a silicon steel sheet constituting a motor stator, an end winding, a magnetic steel constituting a motor rotor, a motor shaft, a motor housing, and the like, to improve heat dissipation efficiency.

With reference to the first aspect, in a seventh possible implementation, the cooling working substance is used for performing contact cooling on the chip of the inverter. The cooling working substance is an insulating working substance, and in this case, isolation design may not be performed. Therefore, there is no safety hazard, and heat dissipation efficiency is improved.

With reference to the first aspect, in an eighth possible implementation, the cooling system further includes a pump unit that is configured to provide power for circulation of the cooling working substance in the cooling circuit. In some embodiments of this application, the first cooling channel is connected to the second cooling channel, and in this case, only one pump unit may be disposed. Therefore, a quantity of pump units, costs, and occupied space are reduced, and this facilitates the powertrain cooling system and the powertrain to evolve towards miniaturization.

According to a second aspect, this application further provides a powertrain cooling method. The cooling method is applied to an electric vehicle and includes: dissipating heat of an inverter of the electric vehicle by using a first cooling channel, and dissipating heat of a motor of the electric vehicle by using a second cooling channel, where the first cooling channel is connected to the second cooling channel to form a cooling circuit; and controlling a cooling working substance to flow from the first cooling channel into the second cooling channel, where the cooling working substance is an insulating working substance.

With reference to the second aspect, in a first possible implementation, when the first cooling channel is connected to the second cooling channel through a bypass valve, and a bypass cooling channel and the second cooling channel are connected in parallel, the method further includes: in a process in which a thermal power of the inverter is increased, or when it is determined that a thermal power of the inverter is to be increased, controlling the bypass valve to increase a proportion of the cooling working substance that is in the first cooling channel and that flows into the bypass cooling channel.

With reference to the second aspect, in a second possible implementation, the method further includes: obtaining a temperature of the inverter; and when the temperature of the inverter is greater than a preset threshold, controlling an operating state of the bypass valve, so that all the cooling working substance in the first cooling channel flows into the bypass cooling channel.

With reference to the second aspect, in a third possible implementation, the method further includes: dissipating heat of a gearbox of the electric vehicle by using an oil cooling circuit, where a cooling working substance in the oil cooling circuit is an oil coolant, and the oil cooling circuit is isolated from the cooling circuit.

With reference to the second aspect, in a fourth possible implementation, the method further includes: disposing a bearing and a high-speed oil seal at a connection end between a motor shaft of the motor and the gearbox.

With reference to the second aspect, in a fifth possible implementation, the method further includes: implementing heat exchange between an integrated vehicle thermal management circuit and the cooling circuit by using a heat exchanger.

With reference to the second aspect, in a sixth possible implementation, the method further includes: performing contact spray cooling on the motor by using the cooling working substance.

With reference to the second aspect, in a seventh possible implementation, the method further includes: performing contact cooling on a chip of the inverter by using the cooling working substance.

With reference to the second aspect, in an eighth possible implementation, the method further includes: providing power for circulation of the cooling working substance in the cooling circuit by using a pump unit.

According to a third aspect, this application further provides a powertrain that includes the powertrain cooling system, the inverter, the motor, and the gearbox described in the foregoing implementations. The inverter is configured to convert a direct current into an alternating current and transmit the alternating current to the motor. The motor is configured to convert the alternating current into mechanical energy to drive an electric vehicle. The gearbox is configured to convert an output rotational speed of a motor shaft of the motor.

Because the powertrain includes the cooling system described in the foregoing implementations, the powertrain has better heat dissipation performance and lower costs.

According to a fourth aspect, this application further provides an electric vehicle that includes the powertrain in the foregoing implementations and a power battery pack. The power battery pack is configured to supply a direct current to an inverter.

A first cooling channel and a second cooling channel in a cooling system of the electric vehicle are connected, and the entire cooling system uses an insulating working substance with preset viscous resistance as a cooling working substance, and does not need to perform secondary heat exchange between a water cooling circuit and an oil cooling circuit through an oil-water heat exchanger, so that an effect of dissipating heat of a motor is improved, and costs of the electric vehicle are reduced.

The technical solutions provided in this application have at least the following technical effects:

The cooling system provided in this application includes the cooling circuit and the cooling working substance. The cooling circuit includes the first cooling channel and the second cooling channel that are connected, the first cooling channel is configured to dissipate the heat of the inverter of the electric vehicle, and the second cooling channel is configured to dissipate the heat of the motor of the electric vehicle. As the first cooling channel is connected to the second cooling channel, and a cooling working substance used in the entire cooling system is an insulating working substance, when circulating in the cooling circuit, the cooling working substance first flows from the first cooling channel into the second cooling channel, to be specific, the cooling working substance first cools the inverter at upstream and then cools the motor at downstream, because the inverter has a stricter requirement on an operating temperature than the motor, and more heat may be quickly absorbed if the inverter is first cooled. In the cooling system, a circuit for dissipating the heat of the inverter is connected to a circuit for dissipating the heat of the motor, and a same cooling working substance is used in the two circuits. Therefore, there is no need to perform the secondary heat exchange between the water cooling circuit and the oil cooling circuit through the oil-water heat exchanger, so that an effect of dissipating heat of the powertrain can be improved.

### BRIEF DESCRIPTION OF DRAWINGS

FIG. 1 is a schematic diagram of an existing powertrain cooling system;
FIG. 2 is a schematic diagram of a powertrain cooling system according to an embodiment of this application;
FIG. 3 is a schematic diagram of another powertrain cooling system according to an embodiment of this application;
FIG. 4 is a schematic diagram of still another powertrain cooling system according to an embodiment of this application;
FIG. 5 is a schematic diagram of an operating state of a cooling system according to an embodiment of this application;
FIG. 6 is a schematic diagram of another operating state of a cooling system according to an embodiment of this application;
FIG. 7 is a schematic diagram of yet another powertrain cooling system according to an embodiment of this application;
FIG. 8 is a schematic diagram of a powertrain cooling method according to an embodiment of this application;
FIG. 9 is a schematic diagram of a powertrain according to an embodiment of this application; and
FIG. 10 is a schematic diagram of an electric vehicle according to an embodiment of this application.

### DESCRIPTION OF EMBODIMENTS

To enable a person skilled in the art to better understand the solutions of this application, an operating principle of a powertrain cooling system on an electric vehicle is first described below.

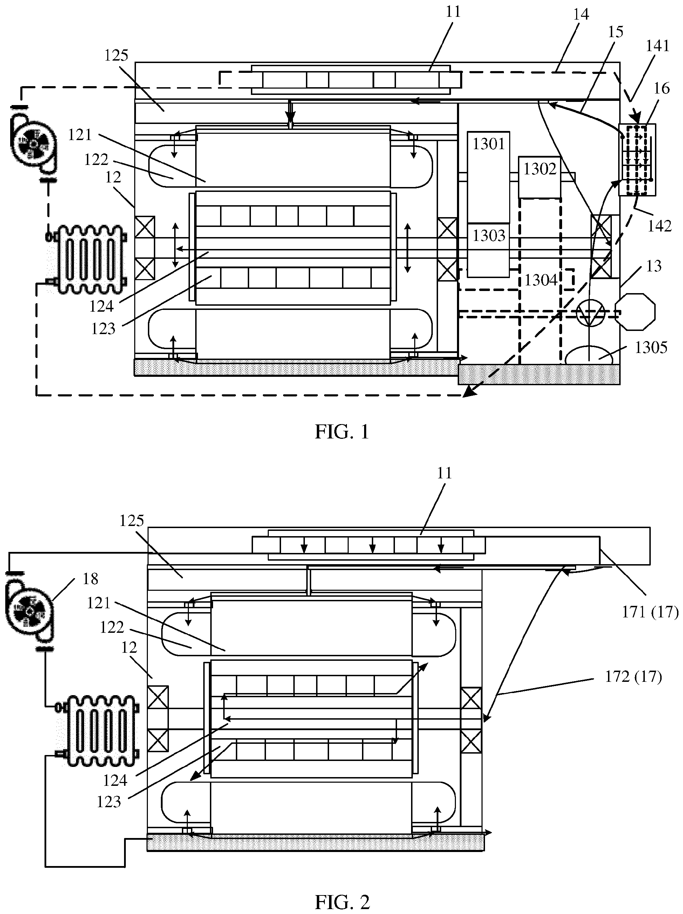

FIG. 1 is a schematic diagram of an existing powertrain cooling system.

A powertrain mainly includes an inverter 11, a motor 12, and a gearbox 13.

The motor 12 includes a silicon steel sheet 121 constituting a motor stator, an end winding 122, a magnetic steel 123 constituting a motor rotor, a motor shaft 124, and a motor housing 125.

The gearbox 13 includes a gear set for decelerating the motor, where the gear set includes a first countershaft gear 1301, a second countershaft gear 1302, an input shaft gear 1303, and an output shaft gear 1304. The gearbox 13 further includes an oil filter 1305.

The powertrain cooling system includes a water cooling circuit 14 (a circuit shown by a dotted arrow in the figure), an oil cooling circuit 15 (a circuit shown by a solid arrow in the figure), and an oil-water heat exchanger 16. The water cooling circuit 14 is not connected to the oil cooling circuit 15.

The water cooling circuit 14 includes a water inlet pipe 141 and a water outlet pipe 142 that are connected to the oil-water heat exchanger 16. As shown in FIG. 1, the water cooling circuit 14 flows through the inverter 11 to dissipate heat of the inverter 11, and then flows through the oil-water heat exchanger 16.

The oil cooling circuit 15 is configured to dissipate heat of the motor 12 and the gearbox 13.

The oil-water heat exchanger 16 includes a channel in the water cooling circuit 14 and a channel in the oil cooling circuit 15, and the two channels are configured to dissipate heat of the oil cooling circuit 15 through the water cooling circuit 14, that is, secondary heat exchange is performed.

In the cooling system, a motor controller (not shown in the figure) first controls the inverter 11 to convert a direct current into an alternating current, during which a part of energy is lost due to conversion efficiency, and this part of energy is converted into heat. In addition, the alternating current enters the motor 12 and is converted, through electromagnetic induction, into mechanical energy for rotating the motor 12, during which heat is produced due to conversion efficiency. Finally, the gearbox 13 reduces a high rotational speed of the motor 12, and this conversion also generates heat. The heat generated by the three parts through energy conversion needs to be timely dissipated from the powertrain through the cooling system.

However, the oil-water heat exchanger 16 hits a bottleneck in heat exchange efficiency, and in this case, heat exchange between an oil coolant and a water coolant can be implemented only when there is a specific temperature difference between the water cooling circuit 14 and the oil cooling circuit 15. Therefore, a temperature of the oil coolant is about 5-15°C higher than that of the water coolant, and accordingly, a maximum temperature of the motor 12 is increased by 5-15°C.

Further, an additional oil-water heat exchanger 16 is needed by oil-water heat exchange in the motor 12, and this increases costs of the cooling system.

To resolve the foregoing problems, this application provides a powertrain cooling system and method, a powertrain, and an electric vehicle. A cooling circuit of the cooling system includes a first cooling channel and a second cooling channel that are connected. The first cooling channel is configured to dissipate heat of an inverter of an electric vehicle, and the second cooling channel is configured to dissipate heat of a motor of the electric vehicle, that is, a cooling circuit of the inverter is connected to that of the motor. Therefore, a process of secondary heat exchange between an oil cooling circuit and a water cooling circuit is not needed, so that an effect of dissipating heat of the powertrain is improved. In addition, an oil-water heat exchanger is not used in the process of secondary heat exchange, and costs of the cooling system are reduced.

To make a person skilled in the art understand the technical solutions in this application better, the following describes the technical solutions in the embodiments of this application with reference to the accompanying drawings in the embodiments of this application.

The terms "first" and "second" in this application are merely intended for a purpose of description, and shall not be understood as an indication or implication of relative importance or an implicit indication of a quantity of indicated technical features.

In addition, in this application, orientation terms such as "upper", and "lower" may be defined by, but are not limited to, orientations of components schematically placed in the accompanying drawings. It should be understood that these orientation terms may be relative concepts, and are used for description and clarification of "relative", and may change correspondingly according to a change in a placement orientation of a component drawing in the drawings.

In this application, unless otherwise expressly specified and limited, the term "connection" should be understood in a broad sense. For example, "connection" may be a fixed connection, a detachable connection or an integral connection; and may be a direct connection or an indirect connection by using an intermediate medium.

In this application, to describe a cooling circuit conveniently, a "circuit" or a "channel" is used to replace a "pipeline" in a physical structure or a container capable of carrying a cooling working substance. In addition, in a corresponding reference drawing, only a line shown by an arrow represents the "circuit" or the "channel". In actual application, a line shown by an arrow corresponds to a radiator pipeline or a corresponding container capable of carrying a cooling working substance.

### Embodiment 1

This embodiment of this application provides a powertrain cooling system, which is described in detail below with reference to a drawing.

FIG. 2 is a schematic diagram of the powertrain cooling system provided in this embodiment of this application.

A powertrain shown in the figure includes an inverter 11 and a motor 12.

The cooling system provided in this embodiment of this application includes a cooling circuit 17 (a circuit shown by a solid arrow in the figure) and a cooling working substance (not shown in the figure).

The cooling circuit 17 specifically includes a first cooling channel 171 and a second cooling channel 172.

The first cooling channel 171 is configured to dissipate heat of the inverter 11 of an electric vehicle, and the second cooling channel 172 is configured to dissipate heat of the motor 12 of the electric vehicle. The first cooling channel 171 is connected to the second cooling channel 172, and a cooling working substance is used in the two channels.

The cooling working substance is an insulating working substance, and a type of the cooling working substance is not specifically limited in this embodiment of this application. However, in actual application, the cooling working substance needs to dissipate the heat of the inverter 11 but the inverter 11 has a high requirement on an operating temperature. Therefore, in some embodiments, an insulating working substance with low viscous resistance may be selected as the cooling working substance, to ensure heat dissipation efficiency of the inverter 11. For a person skilled in the art, the insulating working substance with low viscous resistance means that the viscous resistance of the insulating working substance is less than that of an oil coolant used in the oil cooling circuit 15 in FIG. 1. The cooling working substance meets a heat dissipation requirement of the inverter 11 with high requirements and meets a heat dissipation requirement of the motor 12.

In this embodiment of this application, the insulating working substance with low viscous resistance is not specifically limited, and may be, for example, fluorinated liquid or water-based lubricant. An example is used for description in the following.

In a possible implementation, physical properties of the cooling working substance at 80°C are as follows:

A dynamic viscosity coefficient is equal to 1E-3 to 3E-3 kg/m/s, a coefficient of thermal conductivity is equal to 0.3 to 0.5 W/m/K, a specific heat capacity is equal to 3000 to 4000 J/kg/K, and a density is less than 1000 kg/m3.

The foregoing is merely an example of a possible cooling working substance. A person skilled in the art may alternatively use another type of cooling working substance in the cooling circuit without departing from a principle of this application, and this shall fall within the protection scope of this application.

The insulating working substance does not include water. A person skilled in the art should know that in actual application, when used as the cooling working substance, water is a non-insulating working substance.

An electronic pump 18 is configured to provide power for circulation of the cooling working substance in the cooling circuit 17. When circulating in the cooling circuit 17, the cooling working substance first flows from the first cooling channel 171 into the second cooling channel 172. To be specific, the cooling working substance first dissipates the heat of the inverter 11 at upstream and then dissipates the heat of the motor 12 at downstream. After exchanging heat with the motor 12, the cooling working substance in the second cooling channel 172 returns to an integrated vehicle thermal management circuit, to discharge heat.

In conclusion, by using the cooling system provided in this embodiment of this application, the first cooling channel dissipates the heat of the inverter, the second cooling channel dissipates the heat of the motor, and the first cooling channel is connected to the second cooling channel. Therefore, a process of secondary heat dissipation between a water cooling circuit and an oil cooling circuit is not needed, so that an effect of dissipating heat of the powertrain can be improved. A maximum temperature of the motor may be correspondingly decreased by about 5-15°C, compared with the cooling system shown in FIG. 1. In addition, an oil-water heat exchanger needed by the secondary heat dissipation is not used, so that costs of the cooling system are reduced.

Further, in the cooling system shown in FIG. 1, the oil cooling circuit 15 in the motor 12 needs to be driven by an electronic oil pump to circulate, and because a water cooling circuit for heat dissipation of the inverter 11 needs to be connected in series to the integrated vehicle thermal management circuit, another electronic water pump is needed to drive the water cooling circuit to circulate. Because the two electronic pumps are used, costs are increased and a large space is occupied by disposing the electronic pumps. In the cooling system provided in this application, the first cooling channel is connected to the second cooling channel, so that only one pump unit is needed to provide the power for circulation of the cooling working substance in the cooling circuit. Therefore, costs and occupied space are reduced, and this better meets a requirement that the powertrain cooling system and the powertrain evolve towards miniaturization.

Through research, the inventors have found that the cooling system shown in FIG. 1 has the following disadvantages.

First, because the cooling working substance for cooling the inverter 11 is water that is a conductive working substance, a water-electricity isolation design is needed, which is difficult and has a safety hazard. In addition, because a chip of the inverter 11 cannot be directly cooled and heat dissipation can be performed only indirectly (through thermal conduction), thermal resistance is large and heat dissipation efficiency is low. As a result, a temperature of the chip of the inverter 11 may increase by at least 10°C in some working conditions.

Second, when the motor 12 is cooled, heat dissipation is performed indirectly (through thermal conduction) by using the oil coolant in the oil cooling circuit. In this case, the thermal resistance is also large and the heat dissipation efficiency is also low.

To avoid the first disadvantage, the cooling working substance used in the cooling circuit in this embodiment of this application is an insulating working substance, namely, a non-conductive working substance. In this case, the foregoing safety hazard does not exist. Therefore, in some embodiments, the isolation design may not be performed, and contact cooling is performed on the chip of the inverter, so that heat dissipation efficiency is improved.

To avoid the second disadvantage, in some embodiments, the cooling working substance in the cooling circuit provided in this embodiment of this application may be an insulating working substance with low viscous resistance. Therefore, through spraying cooling, the cooling working substance may be in direct contact with a silicon steel sheet 121 constituting a motor stator, an end winding 122, a magnetic steel 123 constituting a motor rotor, a motor shaft 124, a motor housing 125, and the like, to improve heat dissipation efficiency.

An operating principle of the cooling system when cooling the inverter and the motor is described in the foregoing embodiment, and an operating principle of the cooling system when cooling a gearbox of the motor is described below.

### Embodiment 2

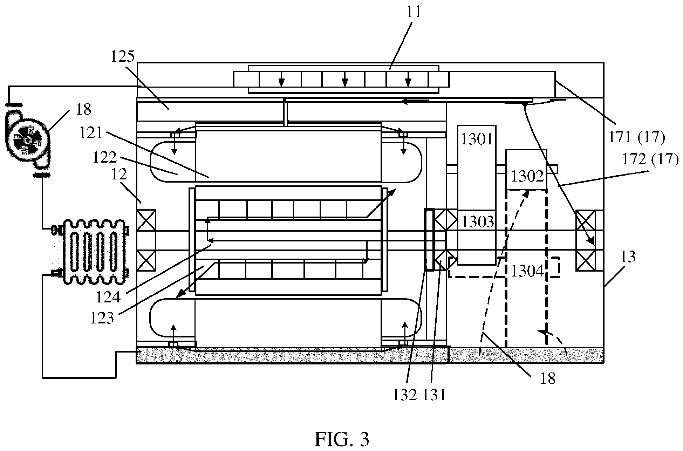

FIG. 3 is a schematic diagram of another powertrain cooling system provided in this embodiment of this application.

A powertrain shown in the figure includes an inverter 11, a motor 12, and a gearbox 13.

A gear set of the gearbox 13 includes a first countershaft gear 1301, a second countershaft gear 1302, an input shaft gear 1303, and an output shaft gear 1304.

The cooling system described in this embodiment of this application includes a cooling circuit 17 (a circuit shown by a solid arrow in the figure), an oil cooling circuit 18 (shown by a dotted arrow in the figure), and a cooling working substance (not shown in the figure).

The cooling circuit 17 includes a first cooling channel 171 and a second cooling channel 172. For detailed descriptions, refer to Embodiment 1. Details are not described herein again in this embodiment of this application.

The oil cooling circuit 18 is isolated from the cooling circuit 17, that is, the oil cooling circuit 18 is independently disposed to dissipate heat of the gearbox 13 of an electric vehicle.

The cooling working substance used in the oil cooling circuit 18 is an oil coolant that has large viscous resistance and a specific lubrication function.

When a gear, for example, the output shaft gear 1304 of the gearbox 13, is rotated, the oil coolant can be agitated, to drive the oil cooling circuit 18.

A bearing 131 and a high-speed oil seal 132 are disposed between the gearbox 13 and the motor 12, to isolate the oil cooling circuit 18 from the cooling circuit 17 and prevent the oil coolant from leaking. The bearing 131 and the high-speed oil seal 132 are disposed at a connection end between a motor shaft 124 of the motor 12 and the gearbox 13.

In conclusion, by using the powertrain cooling system provided in this embodiment of this application, the first cooling channel in the cooling system may be configured to dissipate heat of the inverter, the second cooling channel may be configured to dissipate heat of the motor, and then the independent oil cooling circuit is configured to dissipate the heat of a gearbox of the motor. The first cooling channel is connected to the second cooling channel. Therefore, a process of secondary heat dissipation between a water cooling circuit and an oil cooling circuit is not performed, so that an effect of dissipating heat of the powertrain can be improved. In addition, an oil-water heat exchanger needed by the secondary heat dissipation is not used, so that costs of the cooling system are reduced.

Continue to refer to FIG. 1, that the first cooling channel 171 is directly connected to the second cooling channel 172 is used as an example to describe the foregoing embodiment. In some other embodiments, a mode of connection between the first cooling channel 171 and the second cooling channel 172 may be improved to adjust a heat dissipation capability based on a current operating state of the electric vehicle. Details are described below.

### Embodiment 3

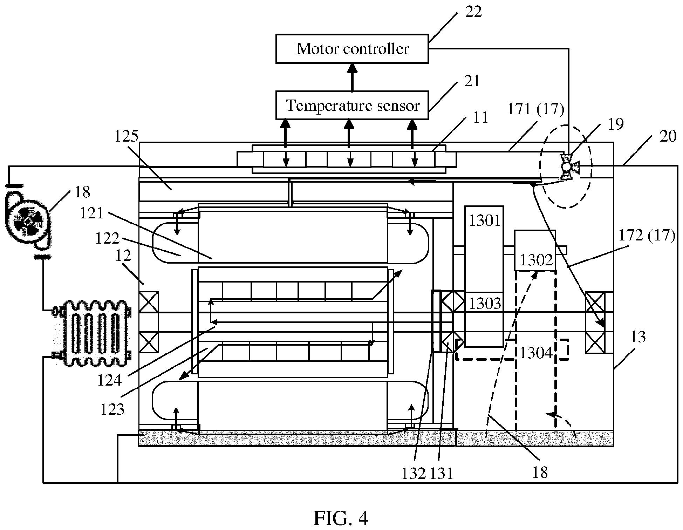

FIG. 4 is a schematic diagram of still another powertrain cooling system provided in this embodiment of this application.

A powertrain shown in the figure includes an inverter 11, a motor 12, and a gearbox 13.

The cooling system described in this embodiment of this application includes a cooling circuit 17 (a circuit shown by a solid arrow in the figure), an oil cooling circuit 18 (shown by a dotted arrow in the figure), and a cooling working substance (not shown in the figure).

The cooling circuit 17 includes a first cooling channel 171 and a second cooling channel 172.

For descriptions of the cooling circuit 17 and an oil cooling circuit 18, refer to the foregoing embodiments. Details are not described herein again in this embodiment of this application.

Different from the cooling system in the foregoing embodiments, the cooling system shown in FIG. 4 further includes a bypass valve 19 and a bypass cooling channel 20.

The bypass valve 19 is a controllable valve, and the first cooling channel 171 is connected to the second cooling channel 172 through the bypass valve 19.

The bypass valve 19 is specifically a three-way valve, and can be configured to connect the bypass cooling channel 20 and the second cooling channel 172 in parallel. To be specific, one end of the bypass cooling channel 20 is connected to the bypass valve 19, and the other end is connected to a tail end of the second cooling channel 172.

The bypass valve 19 is controlled to increase, in a process in which a thermal power of the inverter 11 is increased, or when it is determined that a thermal power of the inverter 11 is to be increased, a proportion of a cooling working substance that is in the first cooling channel 171 that flows into the bypass cooling channel 20.

The proportion of the cooling working substance flowing into the bypass cooling channel 20 is increased, so that this part of the cooling working substance does not flow into the second cooling channel 172. Therefore, this part of the cooling working substance does not absorb heat of the motor 12, but the heat is directly dissipated through an integrated vehicle thermal management circuit. This part of the cooling working substance absorbs less heat and is cooled faster. Further, this part of the cooling working substance may circulate to the first cooling channel 171 faster, to dissipate heat of the inverter 11, that is, a flow rate of the cooling working substance in the first cooling channel 171 is increased, to improve a capability of dissipating the heat of the inverter 11.

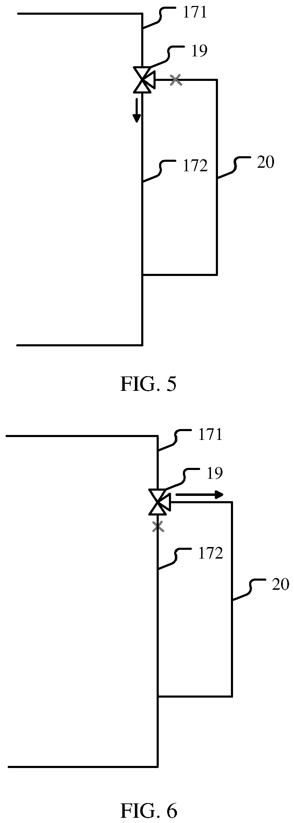

The proportion may be set based on an actual condition and is not specifically limited in this embodiment of this application. In some embodiments, for details, refer to the schematic diagrams of FIG. 5 and FIG. 6. Under normal circumstances, the bypass valve 19 is connected to the first cooling channel 171 and the second cooling channel 172, and no cooling working substance flows into the bypass cooling channel 20. When the inverter needs to be rapidly cooled, the bypass valve 19 may be controlled so that all the cooling working substance in the first cooling channel 171 flows into the bypass cooling channel 20, to improve a capability of dissipating the heat of the inverter 11 to the greatest extent.

The bypass valve 19 may be actively or passively controlled. Details are described below.

The cooling system further includes a temperature sensor 21 and a motor controller 22.

In some embodiments, the bypass valve 19 may be a solenoid valve, and the motor controller 22 can control an operating state of the bypass valve 19.

The temperature sensor 21 is configured to obtain a temperature of the inverter 11 in real time and send the temperature to the motor controller 22.

If the bypass valve is passively controlled, the motor controller 22 controls the operating state of the bypass valve 19 in response to an operation of a driver of an electric vehicle.

If the bypass valve 19 is actively controlled, the motor controller 22 may actively control the operating state of the bypass valve 19 based on a corresponding relationship between a preset temperature of the inverter and the operating state of the bypass valve. For example, in some embodiments, when the temperature of the inverter 11 is greater than a preset threshold, the motor controller 22 controls the operating state of the bypass valve 19, so that all the cooling working substance in the first cooling channel 171 flows into the bypass cooling channel 20, to improve a capability of dissipating the heat of the inverter 11 to the greatest extent.

In some embodiments, the motor controller 22 may be an application-specific integrated circuit (Application-Specific Integrated Circuit, ASIC), a programmable logic device (Programmable Logic Device, PLD), a digital signal processor (Digital Signal Processor, DSP), or a combination thereof. The PLD may be a complex programmable logic device (Complex Programmable Logic Device, CPLD), a field-programmable gate array (Field-programmable Gate Array, FPGA), a generic array logic (Generic Array Logic, GAL), or any combination thereof. This is not specifically limited in this embodiment of this application.

In conclusion, in the cooling system provided in this embodiment of this application, the first cooling channel and the second cooling channel of the cooling circuit are connected through the bypass valve, the bypass cooling channel and the second cooling channel are connected in parallel, and the operating state of the bypass valve is controlled to control the proportion of the cooling working substance that is in the first cooling channel and that flows into the bypass cooling channel. For the powertrain of the electric vehicle, the inverter has a high requirement on an operating temperature. The flow rate or the proportion of the cooling working substance is controlled in the foregoing manner, to improve a capability of dissipating the heat of the inverter and rapidly lower the temperature of the inverter.

That the powertrain cooling system is connected to the integrated vehicle thermal management circuit is used as an example to describe the foregoing embodiments. However, in some embodiments, the powertrain cooling system and the integrated vehicle thermal management circuit may be independent of each other. This is described in detail below with reference to a drawing.

### Embodiment 4

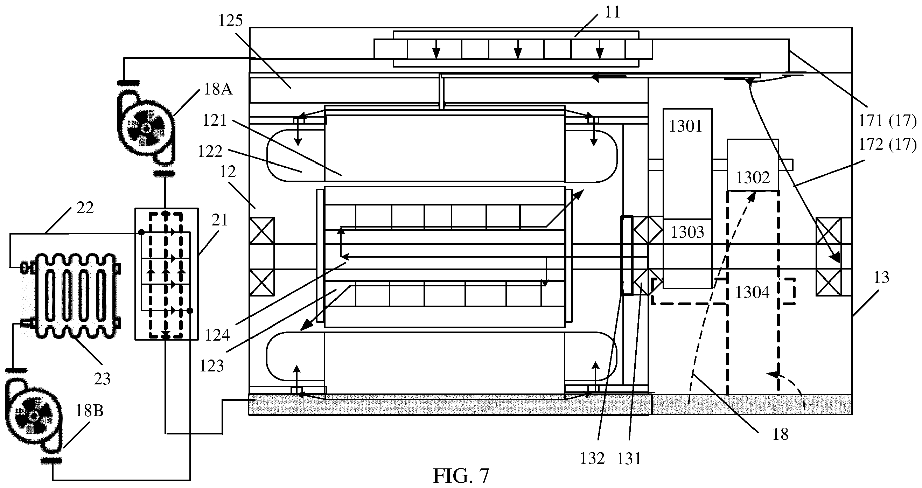

FIG. 7 is a schematic diagram of yet another powertrain cooling system provided in this embodiment of this application.

A powertrain shown in the figure differs from the powertrain in the foregoing embodiments in that: The cooling system is not connected to an integrated vehicle thermal management circuit, but exchanges heat through a heat exchanger 21, to transfer heat to the integrated vehicle thermal management circuit 22. Details are described below.

The heat exchanger 21 of the cooling system includes a first heat exchange channel (a dotted line in the heat exchanger) and a second heat exchange channel (a solid line in the heat exchanger). An input end of the first heat exchange channel is connected to a second cooling channel 172, and an output end of the first heat exchange channel is connected to a first cooling channel 171. The second heat exchange channel is connected to the integrated vehicle thermal management circuit of an electric vehicle. In some embodiments, different types of cooling working substances are used in the two heat exchange channels of the heat exchanger.

The first heat exchange channel is not connected to, but is in sufficient contact with the second heat exchange channel. After a cooling working substance in the second heat exchange channel absorbs heat of a cooling working substance in the first heat exchange channel, heat dissipation is performed through the integrated vehicle thermal management circuit 22.

In this case, an electronic pump 18A provides power for circulation of a cooling working substance in a cooling circuit, and an electronic pump 18B provides power for circulation of a cooling working substance in the integrated vehicle thermal management circuit 22.

In conclusion, the integrated vehicle thermal management circuit is not connected to the powertrain cooling system provided in this embodiment of this application, and heat exchange between the two is performed through a heat exchanger. The integrated vehicle thermal management circuit absorbs heat of the cooling system and releases the heat to an external environment through a radiator 23. Therefore, the foregoing embodiment is applicable to a scenario in which the powertrain cooling system and the integrated vehicle thermal management circuit are independently designed. In the cooling system, the first cooling channel is connected to the second cooling channel. Therefore, there is no need to perform secondary heat exchange between a water cooling circuit and an oil cooling circuit through an oil-water heat exchanger, so that a quantity of oil-water heat exchangers is reduced, and an effect of dissipating heat of the powertrain can be improved.

### Embodiment 5

This embodiment of this application further provides a powertrain cooling method that is used to cool a powertrain of an electric vehicle. The cooling method is described in detail below with reference to a drawing.

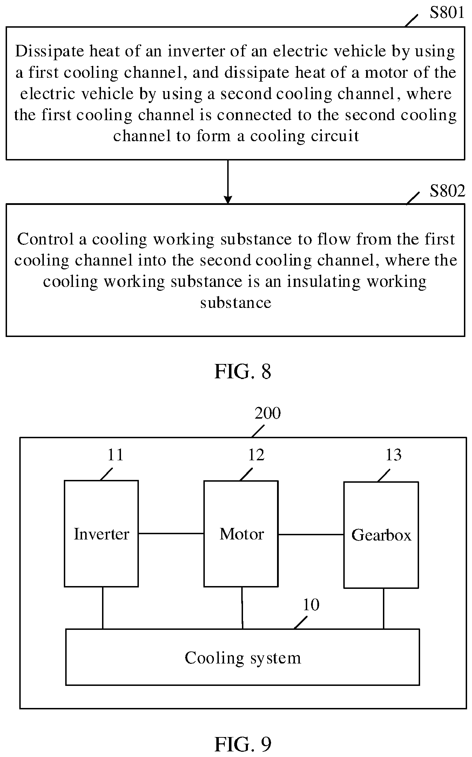

FIG. 8 is a schematic diagram of the powertrain cooling method provided in this embodiment of this application.

The method includes the following steps.

S801: Dissipate heat of an inverter of the electric vehicle by using a first cooling channel, and dissipate heat of a motor of the electric vehicle by using a second cooling channel, where the first cooling channel is connected to the second cooling channel to form a cooling circuit.

S802: Control a cooling working substance to flow from the first cooling channel into the second cooling channel, where the cooling working substance is an insulating working substance.

According to the method used in this embodiment of this application, a process of secondary heat dissipation between a water cooling circuit and an oil cooling circuit is not needed. Therefore, there is no need to perform secondary heat exchange between the water cooling circuit and the oil cooling circuit through an oil-water heat exchanger, so that an effect of dissipating heat of the powertrain can be improved.

Optionally, the first cooling channel may be connected to the second cooling channel through a bypass valve that is a controllable valve. A bypass cooling channel of the cooling circuit and the second cooling channel are connected in parallel. The method further includes:

In a process in which a thermal power of the inverter is increased, or when it is determined that a thermal power of the inverter is to be increased, controlling the bypass valve to increase a proportion of the cooling working substance that is in the first cooling channel and that flows into the bypass cooling channel.

Therefore, a part of the cooling working substance does not flow into the second cooling channel, and then does not absorb heat of the motor. Instead, heat dissipation is performed through an integrated vehicle thermal management circuit. This part of the cooling working substance absorbs less heat and is cooled faster. Further, this part of the cooling working substance may circulate to the first cooling channel faster, to dissipate the heat of the inverter, that is, a flow rate of the cooling working substance in the first cooling channel is increased to improve a capability of dissipating the heat of the inverter.

Further, in some embodiments, a temperature of the inverter may be obtained. When the temperature of the inverter is greater than a preset threshold, an operating state of the bypass valve is controlled so that all the cooling working substance in the first cooling channel flows into the bypass cooling channel, to improve the capability of dissipating the heat of the inverter to the greatest extent, and rapidly dissipate the heat of the inverter.

Optionally, in some embodiments, to cool a gearbox of the motor, an oil cooling circuit may be used to dissipate heat of a gearbox of the electric vehicle. A cooling working substance in the oil cooling circuit is an oil coolant, and the oil cooling circuit is isolated from the cooling circuit.

Optionally, to isolate the oil cooling circuit from the cooling circuit, a bearing and a high-speed oil seal may be disposed at a connection end between a motor shaft of the motor and the gearbox.

Optionally, in some embodiments, a powertrain cooling system and the integrated vehicle thermal management circuit need to be independent of each other. In this case, a heat exchanger may be used to exchange heat between the integrated vehicle thermal management circuit and the cooling circuit, that is, the integrated vehicle thermal management circuit absorbs heat of the cooling system by using the heat exchanger and releases the heat to an external environment through a radiator.

Optionally, because the cooling working substance used in this embodiment of this application is an insulating working substance, isolation design of the cooling working substance and a chip of the inverter may not be performed. The cooling working substance is used for performing contact cooling on the chip of the inverter, to improve efficiency of dissipating the heat of the inverter.

Optionally, the cooling working substance may be used for performing contact spray cooling on the motor. To be specific, through spraying cooling, the cooling working substance can be in direct contact with a silicon steel sheet constituting a motor stator, an end winding, a magnetic steel constituting a motor rotor, a motor shaft, a motor housing, and the like, to improve efficiency of dissipating the heat of the motor.

Optionally, a pump unit may be used to provide power for circulation of the cooling working substance in the cooling circuit. The first cooling channel is connected to the second cooling channel, so that only one pump unit is needed to provide the power for circulation of the cooling working substance in the cooling circuit. Therefore, costs and occupied space are reduced, and this better meets a requirement that the powertrain cooling system and the powertrain evolve towards miniaturization.

### Embodiment 6

Based on the powertrain cooling system provided in the foregoing embodiments, this embodiment of this application further provides a powertrain in which the cooling system is used. The powertrain is described in detail below with reference to a drawing.

FIG. 9 is a schematic diagram of the powertrain provided in this embodiment of this application.

The powertrain 200 provided in this embodiment of this application includes a cooling system 10, an inverter 11, a motor 12, and a gearbox 13.

The inverter 11 is configured to convert a direct current to an alternating current and transmit the alternating current to the motor 12. Energy loss due to conversion efficiency of the inverter is converted into heat.

The motor 12 converts the alternating current into mechanical energy for rotating the motor, during which heat is generated due to conversion efficiency.

The gearbox 13 converts an output rotational speed of a motor shaft of the motor 12, and reduces a high rotational speed of the motor. Loss generated by this conversion is also converted into heat.

The cooling system 10 is used to dissipate heat of the inverter 11, the motor 12, and the gearbox 13, that is, to timely dissipate heat generated by the three devices. For descriptions of the cooling system 10, refer to the foregoing embodiments. Details are not described herein again in this embodiment of this application.

In conclusion, the powertrain provided in this application includes the cooling system, a cooling circuit of the cooling system includes a first cooling channel and a second cooling channel that are connected, the first cooling channel is configured to dissipate heat of the inverter of an electric vehicle, and the second cooling channel is configured to dissipate heat of the motor of the electric vehicle. As the first cooling channel is connected to the second cooling channel, and a cooling working substance used in the entire cooling system is an insulating working substance, when circulating in the cooling circuit, the cooling working substance first flows from the first cooling channel into the second cooling channel, to be specific, the cooling working substance first cools the inverter at upstream and then cools the motor at downstream because the inverter has a stricter requirement on an operating temperature than the motor, and more heat may be quickly absorbed if the inverter is first cooled. Therefore, there is no need to perform secondary heat exchange between a water cooling circuit and an oil cooling circuit through an oil-water heat exchanger, so that an effect of dissipating heat of the powertrain can be improved.

In addition, only one pump unit is needed in the cooling circuit to provide power for circulation of the cooling working substance in the cooling circuit. Therefore, costs and occupied space are reduced, and this better meets a requirement that the powertrain cooling system and the powertrain evolve towards miniaturization.

The insulating working substance is used as the cooling working substance. In this case, isolation design of the cooling working substance and the inverter may not be performed, and contact cooling may be performed on a chip of the inverter. Therefore, efficiency of dissipating the heat of the inverter is improved. Through spraying cooling, the cooling working substance may be in direct contact with a silicon steel sheet constituting a motor stator, an end winding, a magnetic steel constituting a motor rotor, a motor shaft, a motor housing, and the like, to improve efficiency of dissipating the heat of the motor.

### Embodiment 7

Based on the powertrain provided in the foregoing embodiments, this embodiment of this application further provides an electric vehicle in which the powertrain is used. The electric vehicle is described in detail below with reference to a drawing.

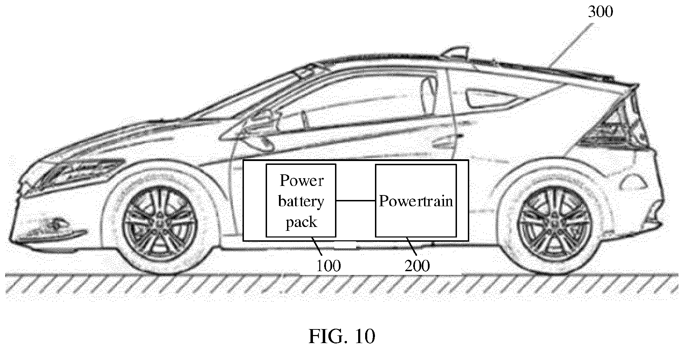

FIG. 10 is a schematic diagram of the electric vehicle provided in this embodiment of this application.

The electric vehicle 300 provided in this embodiment of this application includes a power battery pack 100 and a powertrain 200.

As shown in FIG. 8, the powertrain 200 includes the powertrain cooling system described in the foregoing embodiments. For descriptions of the cooling system, refer to the foregoing embodiments. Details are not described herein again in this embodiment of this application.

The power battery pack 100 is configured to supply a direct current to an inverter of the powertrain 200.

In conclusion, the electric vehicle includes the powertrain cooling system. A cooling circuit of the cooling system includes a first cooling channel and a second cooling channel that are connected. The first cooling channel is configured to dissipate heat of the inverter of the electric vehicle. The second cooling channel is configured to dissipate heat of a motor of the electric vehicle. As the first cooling channel is connected to the second cooling channel, and a cooling working substance used in the entire cooling system is an insulating working substance, when circulating in the cooling circuit, the cooling working substance first flows from the first cooling channel into the second cooling channel, to be specific, the cooling working substance first cools the inverter at upstream and then cools the motor at downstream because the inverter has a stricter requirement on an operating temperature than the motor, and more heat may be quickly absorbed if the inverter is first cooled. Therefore, there is no need to perform secondary heat exchange between a water cooling circuit and an oil cooling circuit through an oil-water heat exchanger, so that an effect of dissipating heat of the powertrain can be improved, and costs of the electric vehicle can be reduced.

In some embodiments, only one pump unit is needed in the cooling circuit may to provide power for circulation of the cooling working substance in the cooling circuit. Therefore, the costs of the electric vehicle are further reduced.

The insulating working substance is used as the cooling working substance. In this case, isolation design of the cooling working substance and the inverter may not be performed, and contact cooling may be performed on a chip of the inverter. Therefore, efficiency of dissipating the heat of the inverter is improved, a design difficulty is simplified, there is no safety hazard when the water cooling circuit in FIG. 1 is used, and safety performance of the electric vehicle is enhanced.

It should be understood that, in this application, "at least one" means one or more, and "a plurality of' means two or more. The term "and/or" is used to describe an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one of the following items (pieces)" or a similar expression thereof indicates any combination of these items, including a single item (piece) or any combination of a plurality of items (pieces). For example, at least one (piece) of a, b, or c may represent: a, b, c, "a and b", "a and c", "b and c", or "a, b, and c", where a, b, and c may be singular or plural.

The embodiments in this specification are all described in a progressive manner, for same or similar parts in the embodiments, refer to these embodiments, and each embodiment focuses on a difference from other embodiments. The device embodiments described above are merely schematic, and units and modules described as separate components may or may not be physically separated. In addition, some or all of the units and modules may be selected based on an actual need, to implement the objectives of the solutions of the embodiments. A person of ordinary skill in the art may understand and implement the embodiments without creative efforts.

The foregoing descriptions are merely specific implementation of this application. It should be noted that a person of ordinary skill in the art may make several improvements or polishing without departing from the principle of this application and the improvements or polishing shall fall within the protection scope of this application.

## Claims

1. A powertrain cooling system, applied to an electric vehicle and comprising a cooling circuit and a cooling working substance, wherein
the cooling circuit comprises a first cooling channel and a second cooling channel that are connected, the first cooling channel is configured to dissipate heat of an inverter of the electric vehicle, and the second cooling channel is configured to dissipate heat of a motor of the electric vehicle; and
the cooling working substance is an insulating working substance, and the cooling working substance flows from the first cooling channel into the second cooling channel.

2. The cooling system according to claim 1, wherein the cooling system further comprises a bypass valve and a bypass cooling channel;
the bypass valve is a controllable valve, and the first cooling channel is connected to the second cooling channel through the bypass valve;
the bypass cooling channel and the second cooling channel are connected in parallel; and
the bypass valve is configured to increase, in a process in which a thermal power of the inverter is increased, or when it is determined that a thermal power of the inverter is to be increased, a proportion of the cooling working substance that is in the first cooling channel and that flows into the bypass cooling channel.

3. The cooling system according to claim 2, wherein the bypass valve is a solenoid valve, and the cooling system further comprises a temperature sensor and a motor controller;
the temperature sensor is configured to obtain a temperature of the inverter and send the temperature to the motor controller; and
the motor controller is configured to control an operating state of the bypass valve when the temperature of the inverter is greater than a preset threshold, so that all the cooling working substance in the first cooling channel flows into the bypass cooling channel.

4. The cooling system according to claim 1, wherein the cooling system further comprises an oil cooling circuit;
the cooling circuit is isolated from the oil cooling circuit; and
a cooling working substance in the oil cooling circuit is an oil coolant, and the oil cooling circuit is configured to dissipate heat of a gearbox of the electric vehicle.

5. The cooling system according to claim 4, further comprising a bearing and a high-speed oil seal, wherein
the bearing and the high-speed oil seal are disposed at a connection end between a motor shaft of the motor and the gearbox.

6. The cooling system according to claim 1, further comprising a heat exchanger, wherein
the heat exchanger comprises a first heat exchange channel and a second heat exchange channel, an input end of the first heat exchange channel is connected to the second cooling channel, an output end of the first heat exchange channel is connected to the first cooling channel, and the second heat exchange channel is connected to an integrated vehicle thermal management circuit of the electric vehicle; and
after the cooling working substance in the second heat exchange channel absorbs heat of the cooling working substance in the first heat exchange channel, heat dissipation is performed through the integrated vehicle thermal management circuit.

7. The cooling system according to any one of claims 1 to 6, wherein the cooling working substance is used for performing contact spray cooling on the motor.

8. The cooling system according to any one of claims 1 to 6, wherein the cooling working substance is used for performing contact cooling on a chip of the inverter.

9. The cooling system according to any one of claims 1 to 6, further comprising a pump unit, wherein the pump unit provides power for circulation of the cooling working substance in the cooling circuit.

10. A powertrain cooling method, applied to an electric vehicle and comprising:
dissipating heat of an inverter of the electric vehicle by using a first cooling channel, and dissipating heat of a motor of the electric vehicle by using a second cooling channel, wherein the first cooling channel is connected to the second cooling channel to form a cooling circuit; and
controlling a cooling working substance to flow from the first cooling channel into the second cooling channel, wherein the cooling working substance is an insulating working substance.

11. The cooling method according to claim 10, wherein the method further comprises:
in a process in which a thermal power of the inverter is increased, or when it is determined that a thermal power of the inverter is to be increased, controlling a bypass valve to increase a proportion of the cooling working substance that is in the first cooling channel and that flows into a bypass cooling channel, wherein the first cooling channel is connected to the second cooling channel through the bypass valve, and the bypass cooling channel and the second cooling channel are connected in parallel.

12. The cooling method according to claim 11, wherein the method further comprises:
obtaining a temperature of the inverter; and
when the temperature of the inverter is greater than a preset threshold, controlling an operating state of the bypass valve, so that all the cooling working substance in the first cooling channel flows into the bypass cooling channel.

13. The cooling method according to claim 10, wherein the method further comprises:
dissipating heat of a gearbox of the electric vehicle by using an oil cooling circuit, wherein a cooling working substance in the oil cooling circuit is an oil coolant, and the oil cooling circuit is isolated from the cooling circuit.

14. The cooling method according to claim 13, wherein the method further comprises:
disposing a bearing and a high-speed oil seal at a connection end between a motor shaft of the motor and the gearbox.

15. The cooling method according to claim 10, wherein the method further comprises:
implementing heat exchange between an integrated vehicle thermal management circuit and the cooling circuit by using a heat exchanger.

16. The cooling method according to any one of claims 10 to 15, wherein the method further comprises:
performing contact spray cooling on the motor by using the cooling working substance.

17. The cooling method according to any one of claims 10 to 15, wherein the method further comprises:
performing contact cooling on a chip of the inverter by using the cooling working substance.

18. The cooling method according to any one of claims 10 to 15, wherein the method further comprises:
providing power for circulation of the cooling working substance in the cooling circuit by using a pump unit.

19. A powertrain, comprising the powertrain cooling system, the inverter, the motor, and the gearbox according to any one of claims 1 to 9, wherein
the inverter is configured to convert a direct current into an alternating current and transmit the alternating current to the motor;
the motor is configured to convert the alternating current into mechanical energy to drive an electric vehicle; and
the gearbox is configured to convert an output rotational speed of a motor shaft of the motor.

20. An electric vehicle, comprising the powertrain according to claim 19 and a power battery pack, wherein the power battery pack is configured to supply a direct current to an inverter.
